# EUROPÄISCHE PATENTSCHRIFT

(11) **EP 1 445 997 B1**
(45) Veröffentlichungstag und Bekanntmachung des Hinweises auf die Patenterteilung: **19.07.2006**
(21) Anmeldenummer: 04000437.6
(22) Anmeldetag: 12.01.2004
(51) Int. Cl.: H05K 7/20, G06F 1/20

(54) **Lüftersteuerung für einen Prozessor**
Fan control for a processor
Commande d'un ventilateur pour un processeur

(30) Priorität: 29.01.2003 DE 10303457
(43) Veröffentlichungstag der Anmeldung: 11.08.2004
(73) Patentinhaber: Fujitsu Siemens Computers GmbH, 80807 München (DE)
(72) Erfinder: Ahn, Georg, 86179 Augsburg (DE); Nöldge, Detlev, 48366 Laer (DE)
(74) Vertreter: Epping - Hermann - Fischer

(56) Entgegenhaltungen:
- US-A1- 2002 085 353
- US-A1- 2002 140 389
- US-A1- 2003 011 984

## Beschreibung

Die Erfindung betrifft eine Lüftersteuerung für einen Prozessor mit einem Temperaturmeßmodul zur Messung einer Prozessortemperatur, einem Speicher, in dem eine Lüfterkennlinie abgelegt ist, und einer Steuervorrichtung, die in Abhängigkeit der gemessenen Prozessortemperatur und der gespeicherten Lüfterkennlinie ein Lüftersteuersignal erzeugt.

Lüftersteuerungen dieser Art werden verwendet, um den Lüfter immer mit einer möglichst geringen Drehzahl zu betreiben, denn eine hohe Lüfterdrehzahl ist immer mit einem hohen Geräuschpegel verbunden, der von Benutzern eines Computers, in den der Prozessor mit dem Lüfter eingesetzt ist, in der Regel als störend empfunden wird. Das Temperaturmeßmodul ist mit dem Prozessor verbunden und in der Lage, über einen in den Prozessor integrierten Temperatursensor die aktuelle Temperatur zu erfassen. Der Temperatursensor wird in dem Prozessor beispielsweise durch eine Halbleiter-Sperrschicht gebildet, da deren elektrisches Verhalten stark temperaturabhängig ist. Temperatursensoren sind bei vielen Prozessoren fest eingebaut, beispielsweise bei den Pentium 4-Prozessoren der Firma Intel. Um den Prozessor in Abhängigkeit der gemessenen Temperatur ansteuern zu können, ist die gespeicherte Lüfterkennlinie vorgesehen. Durch diese ist vorgegeben, bei welcher gemessenen Temperatur der Lüfter mit welcher Leistung betrieben werden soll und welche die maximale Temperatur ist, bei der der vorgesehene Lüfter bei maximaler Drehzahl laufen soll. Die Lüfterkennlinie ist abhängig von dem verwendeten Prozessor und muß individuell an den Prozessor angepaßt werden. Daher wird für jeden Prozessor eine spezifische Lüfterkennlinie generiert und in dem BIOS eines Computers abgespeichert. Da neue Versionen von Prozessoren relativ häufig auf den Markt gebracht werden, ist die Bereitstellzung von BIOS-Bausteinen mit einer aktuellen BIOS-Programmierung verhältnismäßig aufwendig.

Aus US 2002/085353 A1 ist weiter eine Lüftersteuerung bekannt, bei der die Lüfterkennlinie je nachdem, ob zusätzliche Module in das Gerät eingebaut werden, ausgewählt wird.

Aus US 2003/011984 A1 ist eine Lüftersteuerung bekannt, bei der eine geeignete Lüfterkennlinie in Abhängigkeit von der CPU-Temperatur und der verbrauchten Leistung ausgewählt wird.

US 2002/140389 A1 offenbart eine Lüftersteuerung, die in Abhängigkeit der Temperatur der Prozessoreinheit und einer gespeicherten Lüfterkennlinie den Lüfter steuert, wobei die Lüfterdrehzahl kontinuierlich erhöht oder verringert wird.
mit einer aktuellen Bios-Programmierung verhältnismäßig aufwendig.

Aufgabe der Erfindung ist es, eine Lüftersteuerung anzugeben, bei der auf die manuelle Programmierung einer prozessor-individuellen Lüfterkennlinie verzichtet werden kann. Trotzdem soll die Lüfteransteuerung angepaßt an den verwendeten Prozessor erfolgen.

Die Aufgabe wird erfindungsgemäß durch eine Kalibriervorrichtung gelöst, die zum Empfang eines die Erreichung eines Temperaturmaximalwertes anzeigenden Signals des Prozessors eingerichtet ist und durch die die gespeicherte Lüfterkennlinie zur prozessor-individuellen Lüftersteuerung abhängig von der bei Empfang des Signals gemessenen Temperatur anpaßbar ist.

Die Erfindung nützt aus, daß moderne Prozessoren eine interne Temperaturüberwachung haben und bei Erreichen eines maximal zulässigen Temperaturwertes dies signalisieren oder auch Gegenmaßnahmen ergreifen, beispielsweise die Taktrate reduzieren. Durch die erfindungsgemäße Kalibriervorrichtung wird in vorteilhafter Weise bei Erreichen des maximalen Temperaturwertes die Signalisierung des Prozessors mit der aktuell gemessenen Temperatur kombiniert, um die Lüfterkennlinie prozessor-individuell festzulegen.

In einer ersten vorteilhaften Ausführung wird die zuvor gespeicherte Lüfterkennlinie durch die individualisierte Kennlinie überschrieben. In einer anderen Ausführung wird der bei Signalisierung vorliegende Temperaturmeßwert gespeichert und sowohl die universelle Lüfterkennlinie als auch der individuelle Temperaturmaximalwert bei der Lüfteransteuerung berücksichtigt.

Bei einer vorteilhaften Festlegung der Lüfterkennlinie wird der Temperaturwert, bei dem die maximale Lüfterdrehzahl erreicht werden soll, leicht unterhalb des Temperaturwertes festgelegt, bei dem die Signalisierung des Prozessors erfolgt. Dadurch wird vermieden, daß der Prozessor die Temperatur, bei der die Signalisierung erfolgt, in Zukunft erreicht wird, und somit wird auch verhindert, daß der Prozessor Gegenmaßnahmen einleitet, die zwar einer weiteren Temperaturerhöhung entgegenwirken, aber auch eine Leistungsreduzierung zur Folge haben.

Weitere vorteilhafte Ausgestaltungen sind in den Unteransprüchen angegeben.

Die Erfindung wird nachfolgend anhand eines Ausführungsbeispiels näher erläutert. Es zeigt:
- Figur 1: ein Blockschaltbild einer erfindungsgemäßen Lüftersteuerung mit einem Prozessor und einem Lüfter und
- Figur 2: eine erfindungsgemäß festgelegte Lüfterkennlinie.

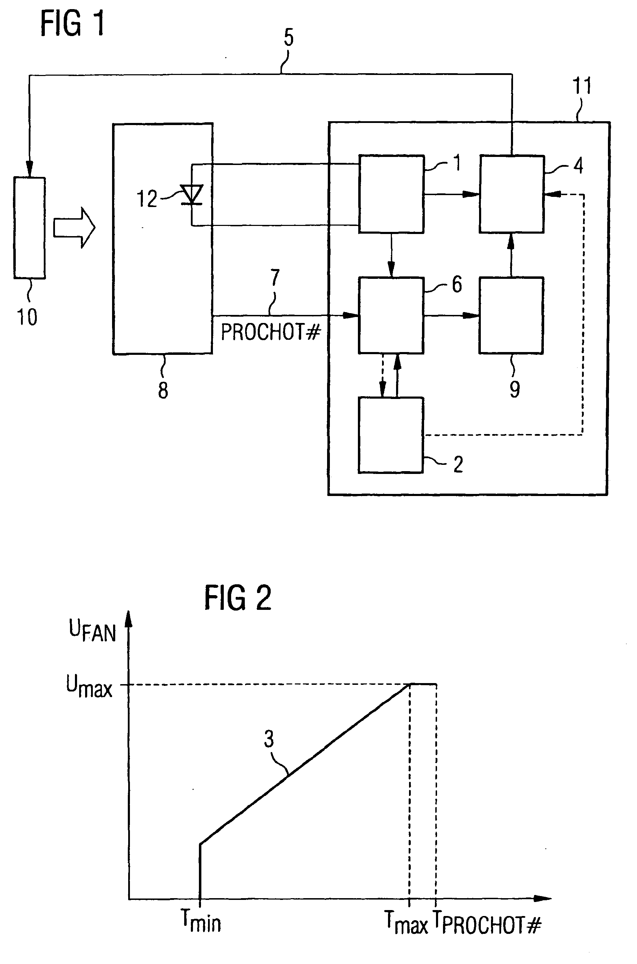

In der Figur 1 ist eine erfindungsgemäße Lüftersteuerung 11, ein Prozessor 8 und ein Lüfter 10 dargestellt. Der Prozessor 8 besitzt eine Temperaturmeßdiode 12, auf die von der Lüftersteuerung 11 zugegriffen werden kann. Die Lüftersteuerung 11 weist ein Temperaturmeßmodul 1, das mit der Temperaturmeßdiode 12 des Prozessors 8 verbunden ist und das die aktuelle Temperatur des Prozessors 8 ermittelt. Außerdem weist die Lüftersteuerung 11 einen Speicher 2 auf, in dem eine Lüfterkennlinie abgelegt ist. Bei einer Lüftersteuerung nach dem Stand der Technik würde die Lüftersteuerung derart erfolgen, daß eine Steuervorrichtung 4 die aktuell gemessene Temperatur, die von dem Temperaturmeßmodul 1 ermittelt wurde, mit der in dem Speicher 2 abgelegten Kennlinie verknüpft wird und daraus ein Steuersignal 5 bildet, das den Lüfter 10 ansteuert. Die Ansteuerung kann in einer einfachen Spannungssteuerung erfolgen, da die Lüfterdrehzahl proportional zur anliegenden Spannung ist. Der Lüfter 10 kühlt dann den Prozessor 8 in der Weise, daß die Lüfterdrehzahl 10 nicht höher ist, als für die aktuelle Wärmeentwicklung im Prozessor 8 erforderlich ist.

Wie eingangs beschrieben muß für jeden Prozessor 8 eine eigene Kennlinie definiert werden. Andererseits kommt es aber auch zu Fertigungstoleranzen bei der Herstellung des Prozessors 8, so daß bei der Festlegung der Lüfterkennlinie zur Berücksichtung der Toleranzen nicht der gesamte zulässige Temperaturbereich des Prozessors 8 ausgenutzt werden kann.

Bei der erfindungsgemäßen Ausgestaltung der Lüftersteuerung wird von dem Prozessor 8 zu der Lüftersteuerung 11 ein Signal 7 übermittelt, mit dem der Prozessor 8 anzeigt, daß ein Temperaturmaximalwert in dem Prozessor 8 erreicht wurde. Bei der Pentium 4-Familie der Firma Intel wird dieses Signal mit PRO-CHOT# bezeichnet. Das Signal wird einerseits intern verwendet, um die Taktfrequenz zu reduzieren, andererseits kann das Signal aber auch an einem Anschlußpin des Prozessors abgegriffen werden. Innerhalb der Lüftersteuerung 11 wird das Signal 7 einer Kalibriervorrichtung 6 zugeführt. Diese ist zudem mit dem Temperaturmeßmodul 1 und dem Speicher 2 verbunden. In dem Speicher 2 ist zunächst eine Universal-Lüfterkennlinie abgelegt. Solange der Prozessor 8 noch in nie seine Maximaltemperatur erreicht hat, wird die Universal-Lüfterkennlinie verwendet. Diese kann jedoch so ausgelegt werden, daß die maximale Lüfterdrehzahl erst bei einer Temperatur erreicht wird, die oberhalb der zu erwartenden maximalen Prozessortemperatur liegt.

Bei der erstmaligen Erreichung der prozessor-internen Maximaltemperatur und der damit erstmaligen Übermittlung des Signals 7 an die Kalibriervorrichtung 6, wird das zukünftige Steuerverhalten der Lüftersteuerung festgelegt. Dazu bieten sich zwei Möglichkeiten.

In einer ersten Möglichkeit wird der bei Anlegen des Signals 7 gemessene Temperaturwert, der von dem Temperaturmeßmodul 1 an die Kalibriervorrichtung 6 übermittelt wird, mit der Universal-Lüfterkennlinie in Speicher 2 verknüpft und die Lüfterkennlinie entsprechend modifiziert. Die modifizierte Lüfterkennlinie wird wiederum im Speicher 2 abgelegt und bei der zukünftigen Lüftersteuerung zugrunde gelegt.

In einer anderen Ausführung bleibt die Universal-Lüfterkennlinie in Speicher 2 erhalten, und es wird nur der bei Auftreten des Signals 7 ermittelte Temperaturwert in einem Speicher 9 abgelegt. Die Steuervorrichtung 4 greift bei der zukünftigen Lüftersteuerung sowohl auf den Speicher 2 als auch auf den Speicher 9 zu, so daß die Steuerung unter Verwendung des aktuell gemessenen Temperaturwerts von Temperaturmeßmodul 1, der gespeicherten Universal-Lüfterkennlinie in Speicher 2 und dem gespeicherten Temperaturwert in Speicher 9 erfolgt.

Es kann vorgesehen werden, daß die Festlegung der Lüfterkennlinie nicht einmalig beim ersten Erreichen der Prozessor-Maximaltemperatur erfolgt, sondern in regelmäßigen Abständen wiederholt wird. Dadurch ist sichergestellt, daß eine beispielsweise auf Alterungsprozessen beruhende Änderung des Temperaturverhaltens in die Lüftereinsteuerung Eingang findet.

Die Lüftersteuerung könnte auch so weitergebildet werden, daß die Lüfterkennlinie so festgelegt wird, daß bei der maximalen Prozessortemperatur zunächst nicht die volle Lüfterdrehzahl gesteuert wird. Bei Benutzern, die die Leistungsfähigkeit des Prozessors nie ausnutzen, würde daher ein sehr leiser Lüfterbetrieb erreicht werden. Bei Nutzern, die die Prozessorleistung besser ausnutzen und daher der Prozessor heißer wird als bei Nutzern mit geringer Prozessorauslastung, würde die Lüftersteuerung die Kennlinie so ändern, daß sie nun beispielsweise für eine mittlere Prozessorausnützung optimiert ist. Bei Nutzern, die die volle Prozessorleistung ausnutzen, würde die Kennlinie so eingestellt werden, daß bei maximaler Prozessortemperatur auch die maximale Kühlleistung bereitgestellt ist. Eine solche Lüftersteuerung stellt somit ein lernfähiges System dar, das die Lüftersteuerung automatisch so konfiguriert, daß die Lüftergeräuschentwicklung so gering wie möglich ist.

Nach einmaliger Ausnützung der vollen Prozessorleistung würde die Kennlinie zwar leistungsorientiert festgelegt werden, durch eine Kombination mit der oben beschriebenen gelegentlichen Neufestlegung der Lüfterkennlinie würde die Lüfterkennlinie aber wieder geräuschoptimiert festgelegt werden, bis der Nutzer dem Prozessor wieder eine höhere Leistung abverlangt.

Die Figur 2 zeigt eine Lüfterkennlinie in einer vereinfachten Darstellung. Unterhalb einer minimalen Temperatur Tₘᵢₙ ist der Lüfter nicht in Betrieb. Erst bei Erreichen dieser Temperatur Tₘᵢₙ springt die am Lüfter anliegende Spannung U_{fan} auf einen minimalen Wert. Bei höheren Temperaturen steigt auch die am Lüfter anliegende Spannung U_{fan} an bis zu einem Maximalwert Uₘₐₓ, der bei einer maximalen Temperatur Tₘₐₓ erreicht wird. Die Temperatur T_{PROCHOT#}, bei der die Signalisierung vom Prozessor 8 erfolgt, daß die Maximaltemperatur des Prozessors 8 erreicht ist, liegt noch um einige Grad oberhalb der maximalen Temperatur Tₘₐₓ.

### Bezugszeichenliste

- 1: Temperaturmeßmodul
- 2: Speicher
- 3: Lüfterkennlinie
- 4: Steuervorrichtung
- 5: Lüftersteuersignal
- 6: Kalibriervorrichtung
- 7: Signal
- 8: Prozessor
- 9: Mittel zur Speicherung
- 10: Lüfter
- 11: Lüftersteuerung

## Patentansprüche

1. Lüftersteuerung für einen Prozessorlüfter mit
- einem Temperaturmeßmodul (1) zur Messung einer Prozessortemperatur,
- einem Speicher (2), in dem eine Lüfterkennlinie (3) abgelegt ist,
- einer Steuervorrichtung (4), die in Abhängigkeit der gemessenen Prozessortemperatur und der gespeicherten Lüfterkennlinie (3) ein Lüftersteuersignal (5) erzeugt,
**gekennzeichnet durch**
eine Kalibriervorrichtung (6), die zum Empfang eines der Erreichung eines Temperaturmaximalwertes anzeigenden Signals (7) des Prozessors (8) eingerichtet ist und **durch** die die gespeicherte Lüfterkennlinie (3) zur Prozessor-individuellen Lüftersteuerung abhängig von der bei Empfang des Signals (7) gemessenen Temperatur anpaßbar ist.

2. Lüftersteuerung nach Anspruch 1,
**dadurch gekennzeichnet, daß**
die angepaßte Lüfterkennlinie an der Stelle der zuvor gespeicherten Lüfterkennlinie in dem Speicher (2) abgelegt ist.

3. Lüftersteuerung nach Anspruch 1,
**dadurch gekennzeichnet, daß**
Mittel (9) vorgesehen sind zur Speicherung des bei Empfang des Signals (7) gemessenen Temperaturwertes (T_{PROCHOT#}) und die Steuervorrichtung (4) ein Lüftersteuersignal in Abhängigkeit der gemessenen Prozessortemperatur, der gespeicherten Lüfterkennlinie (3) und des gespeicherten Temperaturwertes erzeugt.

4. Lüftersteuerung nach einem der Ansprüche 1 bis 3,
**dadurch gekennzeichnet, daß**
die Anpassung der Lüfterkennlinie (3) derart erfolgt, daß die Temperatur (Tₘₐₓ), bei der der Lüfter (10) auf die maximale Lüfterdrehzahl gesteuert wird, leicht unterhalb des gemessenen Temperaturwertes (T_{PROCHOT#}) festgelegt wird.

5. Lüftersteuerung nach einem der Ansprüche 1 bis 4,
**dadurch gekennzeichnet, daß**
die Lüfterkennlinie (3) derart festgelegt ist, daß bei einer minimalen Temperatur (Tₘᵢₙ) der Lüfter (10) auf eine minimale Drehzahl gesteuert wird, bei einer maximalen Temperatur (Tₘₐₓ) der Lüfter (10) auf eine maximale Drehzahl gesteuert wird und bei Temperaturen zwischen der minimalen und der maximalen Temperatur (Tₘᵢₙ, Tₘₐₓ) die Drehzahl kontinuierlich erhöht wird.

## Claims

1. Fan controller for a processor fan having
- a temperature measuring module (1) for measuring a processor temperature,
- a memory (2) in which a fan characteristic curve (3) is stored,
- a control device (4), which generates a fan control signal (5) as a function of the measured processor temperature and the stored fan characteristic curve (3),
**characterized by**
a calibration device (6), which is configured to receive a signal (7) from the processor (8) indicating that a maximum temperature value has been reached, and by means of which the stored fan characteristic curve (3) for processor-specific fan control can be adapted as a function of the temperature measured on receiving the signal (7).

2. Fan controller according to Claim 1,
**characterized in that**
the adapted fan characteristic curve is stored in the memory (2) in place of the previously stored fan characteristic curve.

3. Fan controller according to Claim 1,
**characterized in that**
means (9) are provided for storing the temperature value (T_{PROCHOT#}) measured on receiving the signal (7), and the control device (4) generates a fan control signal as a function of the measured processor temperature, the stored fan characteristic curve (2) and the stored temperature value.

4. Fan controller according to one of the Claims 1 to 3,
**characterized in that**
the adaptation of the fan characteristic curve (3) is performed in such a way that the temperature (Tₘₐₓ) at which the fan (10) is controlled to the maximum fan speed is set slightly below the measured temperature value (T_{PROCHOT#}).

5. Fan controller according to one of the Claims 1 to 4,
**characterized in that**
the fan characteristic curve (3) is defined in such a way that at a minimum temperature (Tₘᵢₙ) the fan (10) is controlled to a minimum speed, at a maximum temperature (Tₘₐₓ) the fan (10) is controlled to a maximum speed, and at temperatures between the minimum and maximum temperature (Tₘᵢₙ, Tₘₐₓ) the speed is increased continuously.

## Revendications

1. Commande de ventilateur pour un ventilateur de processeur, avec
- un module de mesure de la température (1) pour la mesure d'une température du processeur,
- une mémoire (2), dans laquelle une courbe caractéristique du ventilateur (3) est stockée,
- un dispositif de commande (4), qui produit un signal de commande du ventilateur (5) en fonction de la température de processeur mesurée et de la courbe caractéristique de ventilateur stockée (3),
**caractérisée en ce qu'**il est prévu un dispositif de calibrage (6) pour recevoir un signal (7) du processeur (8) indiquant qu'une valeur maximale de la température est atteinte et par lequel la courbe caractéristique du ventilateur stockée (3) peut être adaptée pour la commande de ventilateur propre au processeur en fonction de la température mesurée lors de la réception du signal (7).

2. Commande de ventilateur selon la revendication 1, **caractérisée en ce que** la courbe caractéristique de ventilateur adaptée est stockée dans la mémoire (2) à la place de la courbe caractéristique de ventilateur mémorisée antérieurement.

3. Commande de ventilateur selon la revendication 1, **caractérisée en ce qu'**il est prévu des moyens (9) pour mémoriser la valeur de température (T_{PROCHOT#}) mesurée à la réception du signal (7) et le dispositif de commande (4) produit un signal de commande de ventilateur en fonction de la température de processeur mesurée, de la courbe caractéristique de ventilateur stockée (3) et de la valeur de température mémorisée.

4. Commande de ventilateur selon l'une quelconque des revendications 1 à 3, **caractérisée en ce que** l'adaptation de la courbe caractéristique de ventilateur (3) est effectuée de telle façon que la température (Tₘₐₓ), à laquelle le ventilateur (10) doit être commandé à sa vitesse de rotation maximale, soit fixée légèrement en dessous de la valeur de température mesurée (T_{PROCHOT#}).

5. Commande de ventilateur selon l'une quelconque des revendications 1 à 4, **caractérisée en ce que** la courbe caractéristique de ventilateur (3) est fixée de telle façon que pour une température minimale (Tₘᵢₙ) le ventilateur (10) soit commandé à une vitesse de rotation minimale, que pour une température maximale (Tₘₐₓ) le ventilateur (10) soit commandé à une vitesse de rotation maximale, et que pour des températures comprises entre la température minimale et la température maximale (Tₘᵢₙ, Tₘₐₓ), la vitesse de rotation soit augmentée de façon continue.
